Europäisches Patentamt

European Patent Office

Office européen des brevets

(19)

(11) Publication number: **0 061 930**

**B1**

(12)

# EUROPEAN PATENT SPECIFICATION

(45) Date of publication of patent specification: **12.08.87**

(51) Int. Cl.⁴: **H 03 K 19/195**

(21) Application number: **82301676.1**

(22) Date of filing: **30.03.82**

(54) Josephson-junction logic circuit.

(30) Priority: **31.03.81 JP 46392/81**
**30.06.81 JP 102859/81**
**28.12.81 JP 215711/81**

(43) Date of publication of application:
**06.10.82 Bulletin 82/40**

(45) Publication of the grant of the patent:
**12.08.87 Bulletin 87/33**

(84) Designated Contracting States:
**DE FR GB NL**

(56) References cited:
**US-A-4 117 354**

**IBM TECHNICAL DISCLOSURE BULLETIN, vol.
22, no. 7, December 1979, pages 2954-2956,
New York, USA T. GHEEWALA: "Parallel-
connected current injection or gate for
Josephson technology"**

(73) Proprietor: **FUJITSU LIMITED**
**1015, Kamikodanaka Nakahara-ku
Kawasaki-shi Kanagawa 211 (JP)**

(72) Inventor: **Shinya, Hasuo**
**157-08 Ooba-cho Midori-ku
Yokohama-shi Kanagawa 227 (JP)**
Inventor: **Norio, Fujimaki**
**1867-1-403 Hiyoshihon-cho Kohoku-ku
Yokohama-shi Kanagawa 223 (JP)**

(74) Representative: **Rackham, Stephen Neil et al
GILL JENNINGS & EVERY 53-64 Chancery Lane
London WC2A 1HN (GB)**

(56) References cited:

**IBM TECHNICAL DISCLOSURE BULLETIN, vol.
24, no. 7A, December 1981, pages 3191-3192,
New York, USA H.BEHA et al: "Magnetically
programmable current injection interferometer
logic device"**

# 0 061 930

**Description**

The present invention relates to a Josephson-junction logic circuit and more specifically to a Josephson-junction logic circuit based on SQUID (superconductive quantum interference devices) having nonlinear threshold characteristics.

Conventional Josephson logic gates consisting of multi-junction superconducting quantum interference devices can be divided into two types, i.e. a type with a magnetically coupled gate having input signal lines magnetically coupled to a superconducting loop as disclosed in US—A—3978351 and a type with current-injection gate in which the input signal current is allowed to flow directly into a superconducting loop of the quantum interference device as disclosed in US—A—4117354. US—A—4117354 also discloses that a control line may be magnetically coupled to the superconducting loop. In the magnetically coupled type gate, an input current is fed to the magnetically coupled input signal lines to change the magnetic field coupled with the loop of SQUID whereby the critical current of the gate is changed, and the super-conductive state is switched to the voltage state. In the magnetically coupled gate, however, each of the input currents that are fed to the magnetically coupled control line independently change the critical current. Namely, the input sensitivity is low, and the operating margin is small. The current injection-type gate, in which the input current is allowed to flow directly into the loop of the gate uses the phenomenon that the superconductive state switches to the voltage state when the input current exceeds a threshold value. The current-injection type gate has nonlinear threshold characteristics, and its boundary between the superconductive state and the voltage state changes more rapidly than that of the magnetically coupled gate, making it possible to improve its operating margin. This type of gate, however, has only a limited number of inputs. The number of inputs is two in the case of a two-junction interference device of a current-injection type having a large operating margin.

Further, conventional Josephson logic gates, such as AND gates and OR gates are of different construction. in the Josephson logic circuits which are constructed by using a number of various logic gates, the logic gates must be arrayed in a different manner for each of the types of circuit. In manufacturing the Josephson logic circuits, therefore, photomasks for patterning electrodes and insulating layers must be prepared in all the manufacturing steps for each of the Josephson logic circuits that are to be produced, thereby making it difficult to correct or modify the Josephson logic circuits.

In view of the defects inherent in the above-mentioned conventional art, an aim of the present invention is to increase the number of inputs of a Josephson-junction logic gate, without seriously impairing its input sensitivity.

According to this invention, a Josephson-junction logic circuit comprising a Josephson-junction logic gate including a superconductive inductance loop, two Josephson junctions having substantially equal critical currents in the inductance loop, two current-injection signal input lines connected to opposite ends of an inductance in the superconductive inductance loop and adapted to receive respective input signal currents and a centre tap to the middle of the inductance, is characterised in that two input signal lines are magnetically coupled to the superconductive loop, the Josephson-junction logic gate comprising a logical OR gate when signal currents are applied to the two magnetically coupled input signal lines and a bias current is applied to the centre tap, and the Josephson-junction logic gate comprising a logical AND gate when one of the two magnetically coupled signal input lines has an offset current applied to it.

Various embodiments of logic gates in accordance with this invention will now be described and contrasted with the prior art with reference to the accompanying drawings; in which:—

Figure 1A is an equivalent circuit diagram illustrating a conventional magnetically coupled Josephson-junction logic gate;

Figure 1B is a graph showing the threshold characteristics of the gate shown in Figure 1A;

Figure 2A is an equivalent circuit diagram illustrating a conventional current-injection type Josephson-junction logic gate;

Figure 2B is a graph showing the threshold characteristics of the gate shown in Figure 2A;

Figure 3A is an equivalent circuit diagram of the present invention;

Figure 3B is a plan of the present invention illustrating its physical structure;

Figure 3C is a symbolic representation of the present invention;

Figure 4A is a symbolic representation of the present invention when used as an OR gate;

Figure 4B is a graph showing the threshold characteristics of the present invention when used as an OR gate;

Figure 5A is a symbolic representation of a circuit when the present invention is used as an AND gate;

Figure 5B is a graph showing the threshold characteristics of the present invention when used as an AND gate;

Figure 6 is a circuit diagram of another aspect of the present invention;

Figure 7 is a circuit diagram of a further aspect of the present invention;

Figures 8A and 8B are equivalent circuit diagrams of a variable thershold logic gate for explaining the threshold characteristics of the logic gates in accordance with this invention; and,

Figures 8C and 8D are graphs illustrating the threshold characteristics of the logic gates in accordance with this invention.

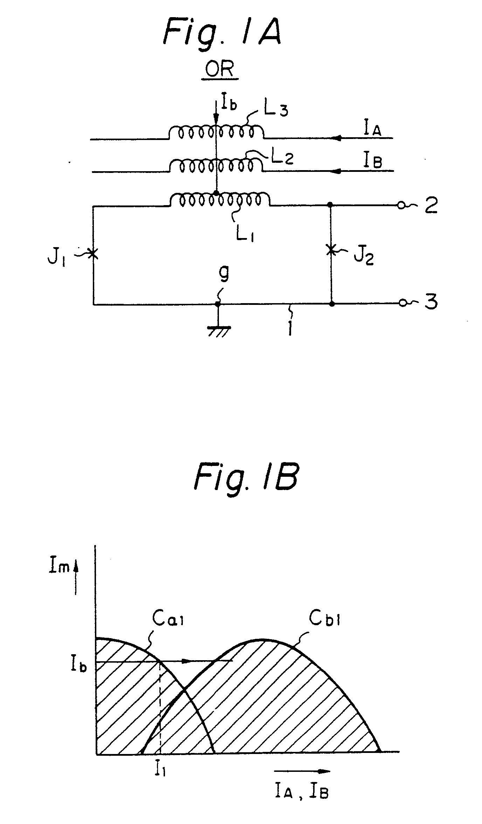

Figure 1A is a diagram of an equivalent circuit of a conventional magnetically coupled OR gate which

2

consists of two Josephson junctions $J_1$ and $J_2$ and an inductance $L_1$ which is connected therebetween. Inductances $L_2$ and $L_3$ are employed being magnetically coupled to the inductance $L_1$ of the superconductive loop 1 which is grounded at a point g. A bias current $I_b$ is supplied to the inductance $L_1$ in the loop, and input currents $I_A$ and $I_B$ are supplied to the inductances $L_2$ and $L_3$ for making magnetic flux into the loop.

Figure 1B is a graph showing the relationships between the critical currents and the input currents of the Josephson junctions in the magnetic field-coupled circuit of Fig. 1A. Referring to Figs. 1A and 1B, it is known that the critical current $I_m$ in the Josephson junction changes as the superconductive loop 1 is magnetically coupled to the magnetic field made by the inductance $L_2$ or $L_3$ owing to the input current $I_A$ or $I_B$. In Fig. 1B, the curves indicated by $C_{a1}$ and $C_{b1}$ represent the relationship between the input current $I_A+I_B$ and the critical current $I_m$. When the bias current $I_b$ is smaller than the critical current $I_m$, indicated by the hatched areas, the gate is in a superconductive state whereby no voltage appears across the output terminals 2 and 3. When the bias current $I_b$ is suitably set as shown so that either the input current $I_A$ or the input current $I_B$ is larger than $I_1$, the Josephson junction assumes the voltage state, whereby a voltage appears across the output terminals 2 and 3. Thus, the circuit of Fig. 1A is used as an OR gate. In the magnetically coupled gate, however, each input current independently changes the critical current and, hence, a small margin is provided for setting a bias current and input currents.

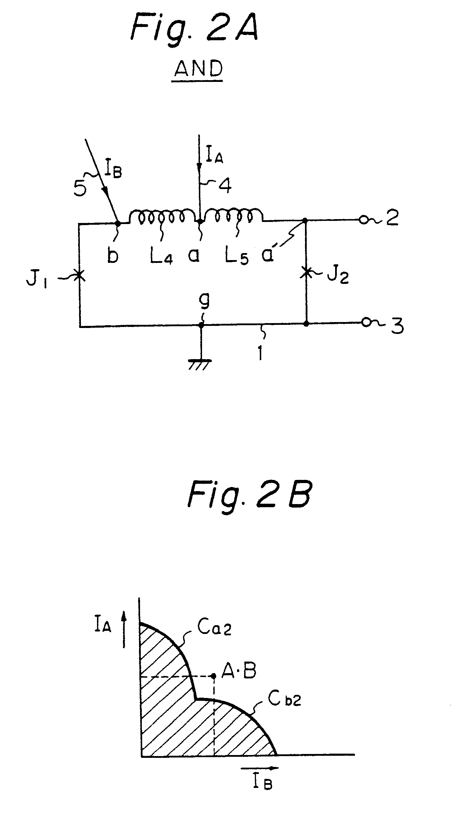

Figure 2A is a diagram of an equivalent circuit of a conventional current-injection type AND gate, in which inductances $L_4$ and $L_5$ are connected in series in the superconductive loop 1 and current injection lines 4 and 5 are disposed at both ends a and b of the inductance $L_4$ to directly inject the input currents $I_A$ and $I_B$.

Figure 2B is a graph illustrating the relationship between the critical current of the Josephson junctions of Fig. 2A and the input currents. In Fig. 2B, the ordinate represents the input current $I_A$ and the abscissa represents the input current $I_B$. When the intersection point of $I_A$ and $I_B$ is in the hatched region, i.e., the current which flows into the superconductive loop 1 is smaller than the predetermined critical current, ths gate is in the superconductive state. When the intersection point of $I_A$ and $I_B$ is at a point outside the hatched area, however, the superconductive state is switched to the voltage state. Thus, the circuit of Figure 2A works as an AND gate. In the current-injection type gate, the state is switched so rapidly relative to the change in the injected current that the operation margin is large. In the two-junction logic gate shown in Figure 2A, however, the number of inputs is limited to two.

One object of the present invention is to solve the above-mentioned problems existing in the conventional magnetically-coupled and current-injection type Josephson-junction logic gates of Figures 1A and 2A.

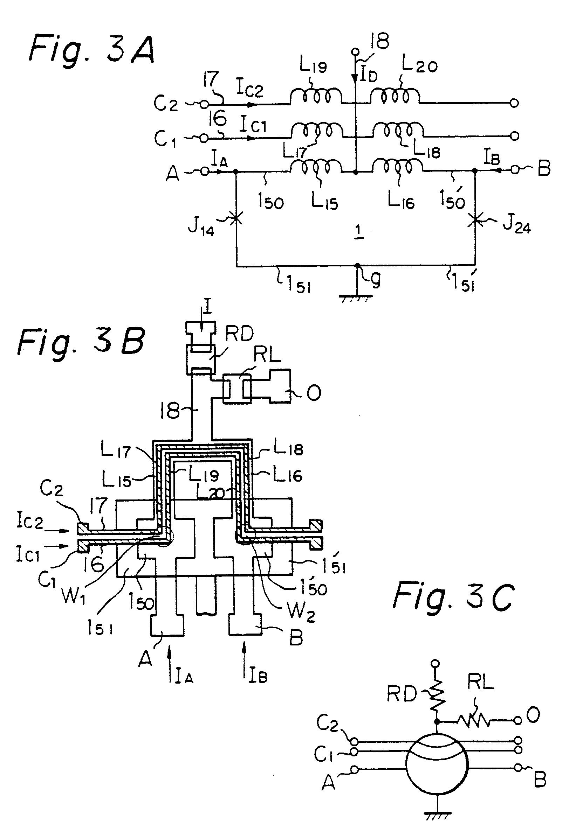

Figure 3A is an equivalent circuit diagram illustrating a superconductive quantum interference element according to the present invention, and Figure 3B is a plan view illustrating the physical structure of the superconductive quantum interference element of Figure 3A and Figure 3C is a diagrammatic repersentation of the superconductive quantum interference element of Figure 3A. The circuit of Figure 3 has inductors $L_{15}$, $L_{16}$ connected in series in a superconductive loop 1 with Josephson junctions $J_{14}$ and $J_{24}$. Terminals A and B receive input currents $I_A$ and $I_B$ and a bias line 18 supplying a bias current $I_D$ is connected to the loop 1 between the inductors $L_{15}$ and $L_{16}$. Magnetically coupled control lines 16 and 17 are provided and this enables the element to function both as an AND gate and an OR gate. Referring to Figures 3A and 3B, the superconductive loop includes base electrodes $I_{50}$ and $I_{50}'$ and counter electrodes $I_{51}$ and $I_{51}'$. The base electrodes include inductance $L_{15}$ and $L_{16}$ connected in series. The counter electrodes $I_{51}$ and $I_{51}'$ are grounded. The counter and base electrodes are each composed of a thin superconductive film, such as a lead alloy or the like. At window portions $W_1$ and $W_2$, the base electrodes are opposed to the counter electrodes through thin insulating films (not shown) capable of causing super-conductive tunneling. The thin insulating films are formed by oxidizing the lower electrodes $I_{50}$ and $I_{50}'$. The Josephson junctions $J_{14}$ and $J_{24}$ are thus formed at the window portions $W_1$ and $W_2$. The other portions of the electrodes, except for the window portions $W_1$ and $W_2$, are insulated by a thick insulating film (not shown) composed of silicon oxide (SiO) or the like. Reference numerals 16 and 17 denote magnetically coupled control lines. The control line 16 has inductances $L_{17}$ and $L_{18}$ which are connected in series. The control line 17 has inductances $L_{19}$ and $L_{20}$ which are connected in series. These control lines 16 and 17 are formed through an insulating film (not shown) under the base electrodes $I_{50}$ and $I_{50}'$ so as to be magnetically coupled to the inductors $L_{15}$ and $L_{16}$.

Reference numeral 18 denotes a bias line, and the symbols RD and RL denote a bias-supplying resistor and an output resistor, respectively. The symbols A and B denote terminals of the lower electrodes $I_{50}$ and $I_{50}'$, $C_1$ and $C_2$ denote terminals of the magnetically coupled control lines 16 and 17, and $O$ denotes an output terminal.

The symbols $I_A$ and $I_B$ denote input currents which are supplied to the base electrodes $I_{50}$ and $I_{50}'$, respectively. Control currents $I_{c1}$ and $I_{c2}$, flow through the magnetically coupled lines 16 and 17, respectively. A bias current $I_D$ flows through a bias line 18.

The Josephson logic gate illustrated in Figs. 3A and 3B has four input terminals, i.e., terminals A and B of the base electrodes $I_{50}$ and $I_{50}'$ and terminals $C_1$ and $C_2$ of the magnetically coupled control lines 16 and 17. An AND gate or an OR gate can be formed by selecting a combination of the four input terminals. That is, the logic gate works as an OR gate when the bias current $I_D$ is allowed to flow into the bias line 18 and

when signal currents $IC_1$ and $IC_2$ are fed to the magnetic field-coupled control lines 16 and 17. The logic gate also works as an AND gate when an offset current $IC_1$ (or $IC_2$) is allowed to flow into the terminal $C_1$ (or $C_2$) of the magnetic field-coupled control line 16 (or 17) and when signal currents are fed to the input terminals A and B.

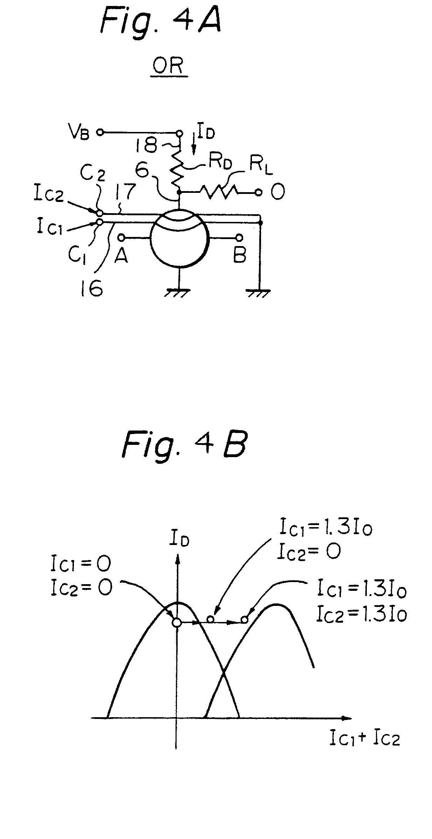

Fig. 4A is symbolic representation of the OR gate obtained as mentioned above with reference to Figs. 3A through 3C and Fig. 4B is a diagram illustrating the threshold characteristics thereof. In this case, the bias current $I_D$ is allowed to flow into the bias line 18 by applying a bias voltage $V_B$ to the bias line 18 and signal currents $I_{C1}$ and $I_{C2}$ are allowed to flow into the terminals $C_1$ and $C_2$ that serve as input terminals.

When either one or both of the signal currents $I_{C1}$ and $I_{C2}$ are 1.3 $I_0$, the circuit assumes the voltage state, as shown in Fig. 4B. When the two signal currents $I_{C1}$ and $I_{C2}$ are zero, the circuit assumes the superconductive state. Namely, a logical sum of the two inputs $C_1$ and $C_2$ is produced at the output terminal $O$.

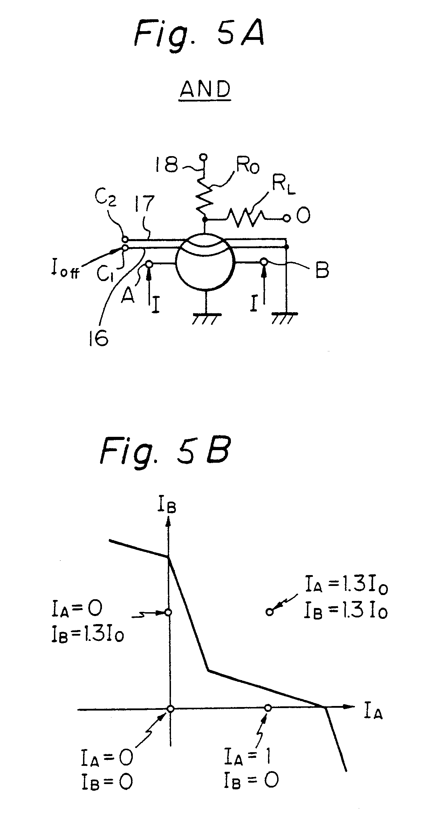

Fig. 5A is a symbolic representation of the AND gate obtained as mentioned above with reference to Figs. 3A through 3C, and Fig. 5B is a diagram showing the threshold characteristics thereof. In this case, an offset current $I_{off}$ is supplied to the magnetic field-coupled control line 16 or 17 and signal currents $I_A$ and $I_B$ are supplied to the base electrodes $I_{50}$ and $I_{50}'$ through the terminals A and B that serve as the two input terminals.

Here, the circuit assumes the voltage state when the signal currents $I_A$ and $I_B$ are both 1.3 $I_0$ and assumes the superconductive state in other cases, as shown in Fig. 5B. That is, a logical product of the two inputs A and B is produced at the output terminal $O$.

Therefore, either the AND gate or the OR gate can be constituted by selecting, on the one hand, the desired threshold characteristics, the selection being effected by supplying an offset current $I_{off}$ to either one of the magnetically coupled control line 16 (or 17) or by supplying a bias current $I_D$ to the bias line 18, and by selecting on the other hand, the input teminals that are to be used.

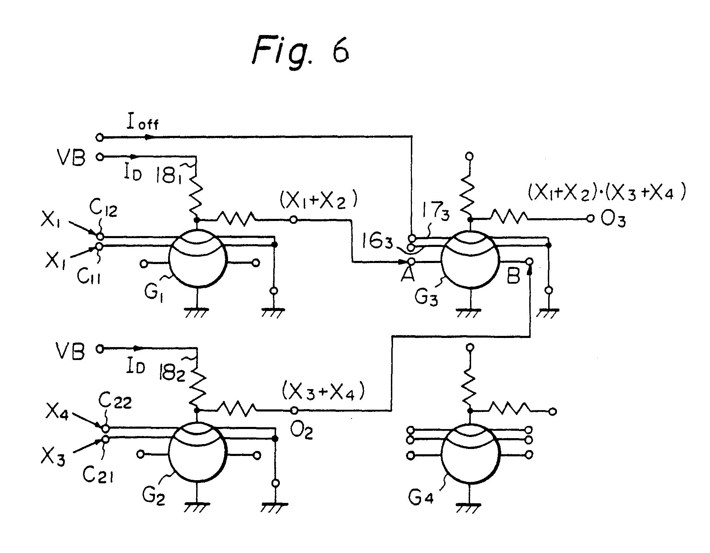

Fig. 6 is a circuit diagram illustrating a Josephson-junction logic circuit according to a second embodiment of the present invention. In Fig. 6, a plurality of Josephson-junction logic gates $G_1$, $G_2$, $G_3$, $G_4$,... each consisting of a superconductive quantum interference element having variable threshold characteristics, are arrayed in the form of a matrix. The bias lines $18_1$ and $18_2$ of the gates $G_1$ and $G_2$ respectively, are connected to a bias voltage source VB, and a bias current ID is supplied to each of the bias lines $18_1$ and $18_2$. Thus, each of the gates $G_1$ and $G_2$ is constituted as an OR gate in the same way as in Fig. 4A, while, with respect to the gate $G_3$, an offset current $I_{off}$ is fed to either one of the magnetically coupled control lines $16_3$ and $17_3$ of the gate $G_3$. The output terminals $O_1$ and $O_2$ of the gates $G_1$ and $G_2$ are connected to the input terminals $A_3$ and $B_3$ of the lower electrodes of the gate G. Thus, the gate $G_3$ is constituted as an AND gate in the same way as in Fig. 5A. When input $X_1$ and $X_2$ are supplied to the input terminals $C_{11}$ and $C_{21}$ of the OR gate $G_1$ and when inputs $X_3$ and $X_4$ are supplied to the input terminals $C_{12}$ and $C_{22}$ of the OR gate $G_2$, a logical sum $(X_1+X_2)$ is obtained at the output terminal $O_1$ of the OR gate $G_1$ and a logical sum $(X_3+X_4)$ is obtained at the output terminal $O_2$ of the OR gate $G_2$. Accordingly, a logical product $(X_1+X_2) \cdot (X_3+X_4)$ is obtained at the output terminal $O_3$ of the AND gate $G_3$. Therefore, the circuit of Fig. 6 is a logic circuit for obtaining the logical product $(X_1+X_2) \cdot (X_3+X_4)$ from the inputs $X_1$, $X_2$, $X_3$, and $X_4$.

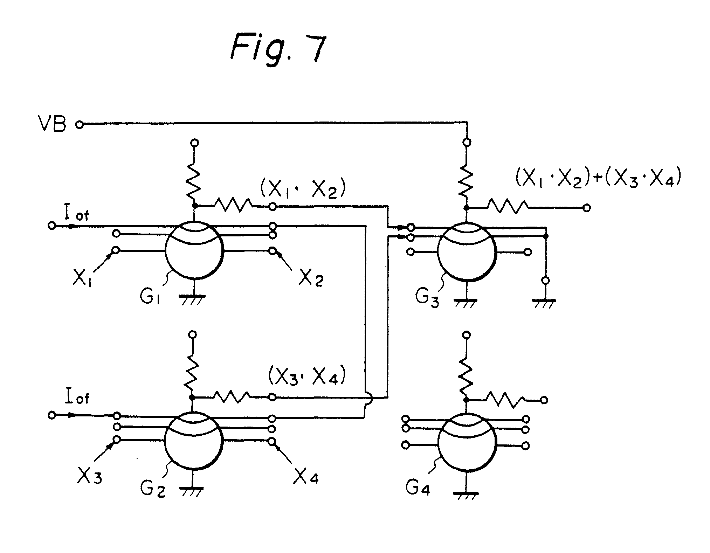

Fig. 7 is a circuit diagram illustrating a Josephson-junction logic circuit according to a third embodiment of the present invention. In Fig. 7, the gates $G_1$ and $G_2$ are utilized as AND gates, and the gate $G_3$ is utilized as an OR gate among the Josephson-junction logic gates $G_1$, $G_2$, $G_3$, $G_4$,.... This embodiment produces a logical sum of two logical products $X_1 \cdot X_2$ and $X_3 \cdot X_4$ from two sets of inputs $X_1$ and $X_2$ and $X_3$ and $X_4$, i.e., a logical sum $(X_1 \cdot X_2 + X_3 \cdot X_4)$.

In the second and third embodiments, the superconductive quantum interference elements of the same construction having variable threshold characteristics are arrayed in the form of a matrix, and desired wirings are provided. Each of the elements has two lower electrodes that serve as input terminals, two magnetically coupled control lines, one bias line, and one output terminal. To constitute a predetermined Josephson logic circuit using the elements as desired logic gates, the wirings are connected to terminals that are selected depending upon the desired logic gates.

Therefore, the second and third embodiments can be realized by simply modifying the wiring pattern only without changing the arrangement or construction of the logic gates.

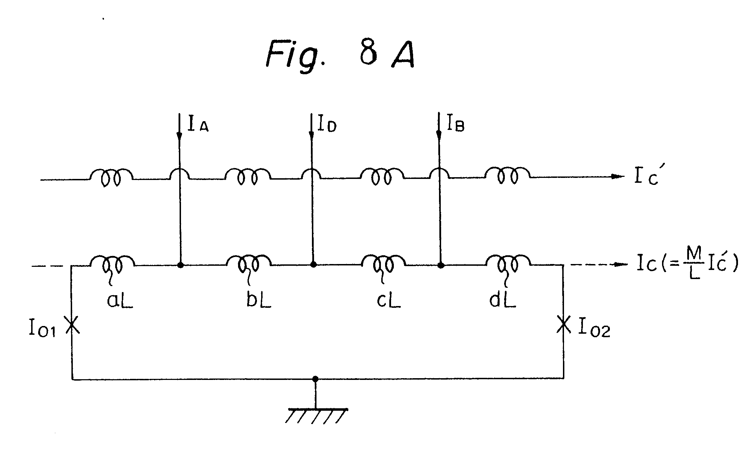

Finally, the theory for obtaining a graph representing threshold characteristics will be described with reference to Figs. 8A through 8D.

Fig. 8A illustrates an equivalent circuit diagram of a variable threshold logic gate in which two Josephson-junctions having critical currents $I_{01}$ and $I_{02}$ are connected through inductance L. Three terminals ($I_A$, $I_D$, and $I_B$) for injecting currents are provided at points that divide the inductance L into $a:b:c:d$ $(a+b+c+d=1)$, and a current $I_c'$ is supplied to a control line that is coupled to the loop through mutual inductance M. The same holds true when the expression

$$Ic\left(=\frac{M}{L}I_c'\right)$$

is employed instead of $I_c'$.

The conventional current-injection type is established when currents $I_A$ and $I_B$ only are supplied, and a two-junction, magnetically coupled SQUID is established when $I_D$ and $I_C$ are supplied or when $I_A$ (or $I_B$) and $I_C$ are supplied.

The following expressions are a Kirchhoff's equation which represents the zero-voltage state of the equivalent circuit of Fig. 8A, and an equation that represents the quantizing condition for a quantum interference element.

$$I_A + I_B + I_D = I_{01} Sin\phi_1 + I_{02} Sin\phi_2 \qquad (1)$$

$$\phi_1 - \phi_2 + \frac{2\pi}{\phi_0} \cdot \Phi = 0 \qquad (2)$$

where $\phi_1$ and $\phi_2$ represent phase differences of Josephson junctions, and $\Phi_0$ represents flux quantum ($h/2e = 2.07 \times 10^{-15}$ Wb, where h denotes Planck's constant, and e denotes electronic charge). Further, $\Phi$ denotes the total magnetic flux which crosses the loop and which is given by,

$$\Phi = (a+b)LI_{01}sin\phi_1 - bLI_A - (c+d)LI_{02}sin\phi_2 + CLI_B - LI_C \qquad (3)$$

When $I_A$, $I_B$, $I_C$ and $I_D$ are given, $\phi_1$ and $\phi_2$ and $\Phi$ are found from the equations (1) through (3), where a minimum value of current in a range where solutions exist define threshold characteristics. For instance, threshold characteristics on a plane $I_B - I_A$ can be obtained if a maximum value and a minimum value of $I_B$ are found by changing $I_A$ while setting $I_C$ and $I_D$ constant. Generally speaking, a curved surface of threshold values exists in a four-dimensional space of $I_A$, $I_B$, $I_C$ and $I_D$, from where threshold characteristics are obtained corresponding to various combinations of the variables. The shape representing the threshold characteristics can be determined by $I_{01}$ and $I_{02}$ or by a, b, c and d.

The equation (3) can be written as follows if the order of the terms in the equation (3) is changed,

$$\Phi = (a+b)LI_{01}sin\phi_1 - (c+d)LI_{02}sin\phi_2 - LI_H \qquad (3')$$

where $I_H = I_C + bI_A - CI_B$

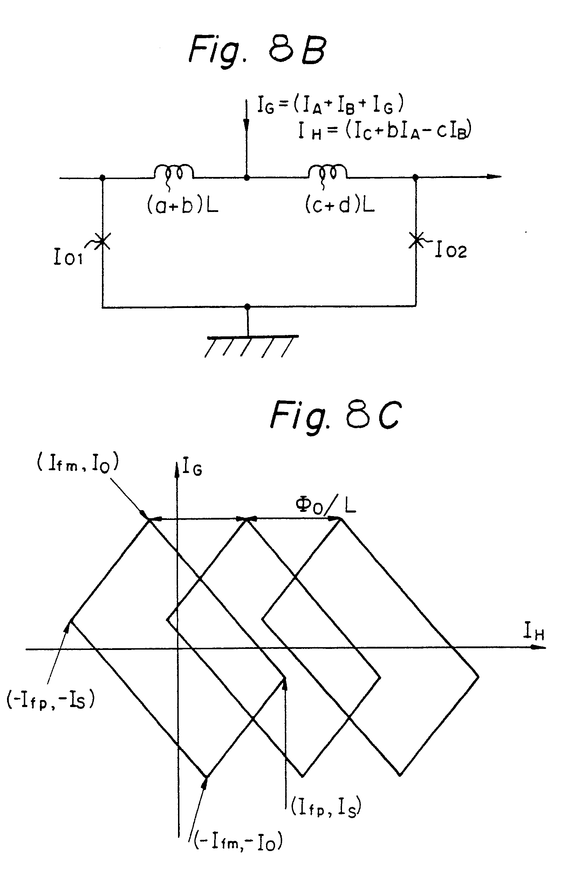

The equations (1), (2), and (3') are the same ones as in the case of the field-coupled circuit shown in Fig. 8B, which circuit diagram is a further equivalent circuit diagram of Fig. 8A. The threshold characteristics of the circuit of Fig. 8B have a well-known periodically occurring shape. Figure 8C shows characteristics approximated by polygonal lines. The following expressions (5) through (7) represent the meaning of the symbols at coordinate points in Fig. 8B.

$$I_o = I_{01} + I_{02} \qquad (4)$$

$$I_s = I_{01} - I_{02} \qquad (5)$$

$$I_{fp} = \frac{\Phi_0}{2L} + (a+b)I_{01} + (c+d)I_{02} \qquad (6)$$

$$I_{fm} = (a+b)I_{01} - (c+d)I_{02} \qquad (7)$$

Figure 8C is a graph illustrating one aspect of the threshold characteristics of the circuit of Fig. 8B.

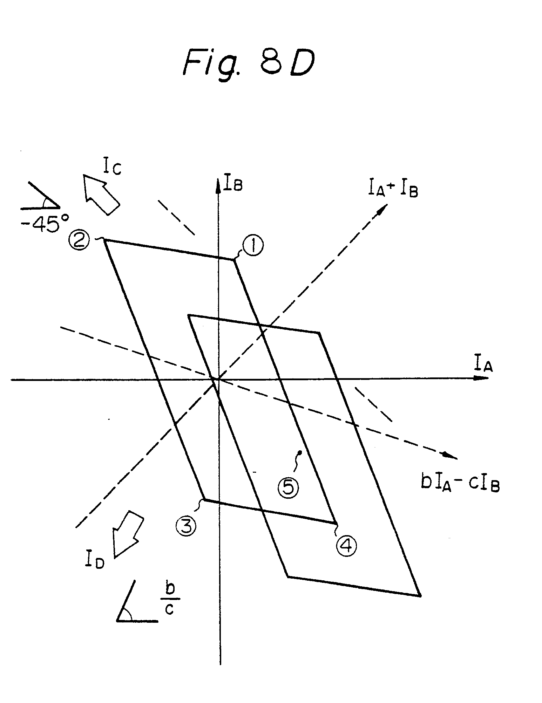

Since $I_G$ and $I_H$ include four currents $I_A$, $I_B$, $I_C$ and $I_D$, the threshold characteristics of the variable threshold logic gate of Fig. 8B can be easily obtained by geometrically shifting the coordinates of the diagram of Fig. 8B. For example, when $I_C = 0$ and $I_D = 0$, the characteristics of Fig. 8C, can be written onto a plane $I_B - I_A$, as illustrated in Fig. 8D. The characteristics in Fig. 8D appear endlessly along a line of $-45°$, maintaining the same shape of mode and an equal distance. In Fig. 8D, two modes of the characteristics are shown. Reference numerals ① through ④ denote coordinates of four corners of a parallelogram which represents the threshold characteristics of the first mode. Reference numerals ⑤ denotes the coordinate of the center of the parallelogram of the second mode. The two arrows indicate the directions in which the parallelogram is shifted in parallel when $I_C$ and $I_D$ are supplied, respectively. When $I_C$ and $I_D$ are both zero, the coordinates ①, ②, ③, ④, and ⑤ can be expressed in the following way:

$$①(\frac{CI_o + I_{fm}}{b+c} + \alpha, \frac{bI_o - I_{fm}}{b+c} + \beta)$$

$$②(\frac{-CI_s - I_{fp}}{b+c} + \alpha, \frac{-bI_s + I_{fp}}{b+c} + \beta)$$

$$③(\frac{-CI_0-I_{fm}}{b+c}+\alpha, \quad \frac{-bI_0+I_{fm}}{b+c}+\beta)$$

$$④(\frac{-CI_s+I_{fp}}{b+c}+\alpha, \quad \frac{bI_s-If_p}{b+c}+\beta)$$

$$⑤(\frac{1}{b+c}\times\frac{n\Phi_0}{L}+\alpha, \quad \frac{1}{b+c}\times\frac{n\Phi_0}{L}+\beta)$$

where,

$$\alpha=\frac{-CI_D-I_C}{b+c}, \quad \beta=\frac{-bI_0+I_C}{b+c},$$

and n represents the number of the mode. It will be understood that the threshold characteristics will be shifted in parallel in the direction of $-45°$ when the current $I_C$ is supplied and will be shifted in the direction of the line tilted by b/c when the current $I_D$ is supplied. The amount of shift can be continuously changed in proportion to $I_D$ or $I_C$. Therefore, the threshold characteristics on the plane $I_B-I_A$ can be shifted in parallel to any position relying upon $I_C$ and $I_D$.

From the foregoing description, it will be apparent that, according to the present invention, the number of inputs for a Josephson-junction logic gate can be increased in comparison with the prior art, without seriously impairing the input sensitivity, by providing magnetic field-coupled control lines for injecting input signals to the current injection-type Josephson-junction gate.

Further, according to the present invention, there is provided a Josephson logic circuit which is capable of forming different logic circuits simply by changing the photomask for the wiring without changing the arrangement or the construction of the logic gates. Consequently, the Josephson logic circuit can be prepared, modified, or corrected very easily.

The present invention should in no way be limited to the gates for obtaining logic functions, illustrated by way of the above-mentioned embodiments, but encompasses various other modifications.

In the second and third embodiments illustrated in Figures 6 and 7, the number of inputs of each Josephson-junction logic gate is two. However, the number of inputs need not be limited to two. It is, of course, allowable to provide three or more magnetic field-coupled control lines and three or more lower electrodes so as to increase the number of inputs.

**Claims**

1. A Josephson-junction logic circuit comprising: a Josephson-junction logic gate including a superconductive inductance loop (1), two Josephson junctions $(J_{14}, J_{24})$ having substantially equal critical currents $(I_0)$ in the inductance loop (1), two current-injection signal input lines $(I_{50}, I_{50}')$ connected to opposite ends of an inductance $(L_{15}, L_{16})$ in the superconductive inductance loop (1) and adapted to receive respective input signal currents $(I_A, I_B)$ and a centre tap (18) to the middle of the inductance $(L_{15}, L_{16})$, characterized in that two input signal lines $(C_1, C_2)$ are magnetically coupled to the superconductive loop (1), the Josephson-junction logic gate comprising a logical OR gate when signal currents $(I_{C1}, I_{C2})$ are applied to the two magnetically coupled input signal lines $(C_1, C_2)$ and a bias current $(I_D)$ is applied to the centre tap (18), and the Josephson-junction logic gate comprising a logical AND gate when one of the two magnetically coupled signal input lines $(C_1, C_2)$ has an offset current applied to it.

2. A Josephson-junction logic circuit according to claim 1, which includes more than one Josephson-junction logic gate $(G_1-G_4$, Figure 6 or Figure 7) and in which each Josephson-junction logic gate $(G_1, G_2, G_3, G_4)$ has at least three input terminals and at least one output terminal, a combination of at least two of the three input terminals being selected to produce a required logic function, and wiring being provided between the selected input terminals and output terminals of the Josephson-junction logic gates $(G_1, G_2, G_3, G_4)$ to interconnect them to provide the required logic function.

3. A Josephson-injection logic circuit according to claim 2, in which the outputs of two logical OR gates are connected to the input of a logical AND gate.

4. A Josephson-junction logic circuit according to any one of the preceding claims, in which the superconductive inductance loop (1) has a grounded point (g).

5. A Josephson-junction logic circuit according to any one of the preceding claims, in which the Josephson-junction logic gates are formed by variable threshold quantum interference elements.

6. A method of operating a Josephson-junction logic circuit having at least one Josephson-junction logic gate including a superconducting loop (1) and two Josephson-junctions $(J_{14}, J_{24})$ formed in it having substantially equal critical currents, two current-injection signal input lines $(I_{50}, I_{50}')$ connected to opposite

6

ends of an inductance ($L_{15}$, $L_{16}$) in the superconductive inductance loop, a centre tap (18) in the middle of the inductance ($L_{15}$, $L_{16}$), and two magnetically coupled input signal lines (16, 17) for injecting signals into the super conductive inductance loop (1), the method comprising applying signal currents ($C_1$, $C_2$) to the magnetically coupled input signal lines (16, 17), and a bias current to the centre tap (18), to cause the Josephson-junction logic gate to operate at a logical OR gate, or applying an offset circuit ($C_1$, $C_2$) to one of two magnetically coupled input lines (16, 17) to cause the Josephson-junction logic gate to operate as a logical AND gate.

## Patentansprüche

1. Logische Schaltung mit Josephson-Übergang mit: einem Logikglied mit Josephson-Übergang, welches einen supraleitenden Induktanzkreis (1), zwei Josephson-Übergänge ($J_{14}$, $J_{24}$), welche im wesentlichen gleiche kritische Ströme ($I_0$) in dem Induktionskreis (1) haben, zwei Strom-Injektions-Signaleingangsleitungen ($I_{50}$, $I_{50}'$), die mit entgegengesetzten Enden einer Induktanz ($L_{15}$, $L_{16}$) in dem superleitenden Induk- tanzkreis (1) verbunden und angepaßt sind, um jeweilige Eingangssignalsströme ($I_A$, $I_B$) zu empfangen, und einen Mittelabgriff (18) zu der Mitte der Induktanz ($L_{15}$, $L_{16}$) umfaßt, dadurch gekennzeichnet, daß zwei Eingangssignalleitungen ($C_1$, $C_2$) mit dem supraleitenden Kreis (1) magnetisch gekoppelt sind, das Logikglied mit Josephson-Übergang ein logisches Oder-Glied bildet, wenn Signalströme ($I_{C1}$, $I_{C2}$) dem bieden magnetisch gekoppelten Eingangssignalleitungen ($C_1$, $C_2$) zugeführt werden und ein Vorspannungsstrom ($I_D$) dem Mittelabgriff (18) zugeführt wird, und das Logik- glied mit Josephson-Übergang ein logisches UND-Glied umfaßt bildet, wenn einer der beiden magnetisch gekoppelten Signaleingangsleitungen ($C_1$, $C_2$) ein Versetzungsstrom zugeführt wird.

2. Logische Schaltung mit Josephson-Übergang nach Anspruch 1, welche mehr als ein Logikglied mit Josephson-Übergang ($G_1$—$G_4$, Figur 6 oder Figur 7) umfaßt und bei welcher jedes Logikglied mit Josephson-Übergang ($G_1$, $G_2$, $G_3$, $G_4$) wenigstens drei Eingangsanschlüsse und wenigstens einen Ausgangsanschluß hat, eine Kombination von wenigstens zwei der drei Eingangsanschlüsse ausgewählt wird, um eine erforderliche logische Funktion zu erzeugen, und eine Verdrahtung zwischen den ausgewählten Eingangsanschlussen und Ausgangsanschlüssen der Logikglieder mit Josephson-Übergang ($G_1$, $G_2$, $G_3$, $G_4$) vorgesehen ist, um sie miteinander zu verbinden, um die erforderliche logische Funktion zu erzeugen.

3. Logische Schaltung mit Josephson-Übergang nach Anspruch 2, bei welcher die Ansgänge der beiden logischen ODER-Glieder mit dem Eingang eines logischen UND-Gliedes verbunden sind.

4. Logische Schaltung mit Josephson-Übergang nach einem der vorhergehenden Ansprüche, bei welcher der supraleitende Induktanzkreis (1) einen geerdeten Punkt (g) hat.

5. Logische Schaltung mit Josephson-Übergang nach einem der vorhergehenden Ansprüche, bei welcher die Logikglieder mit Josephson-Übergang durch Quantum-interferenzelemente mit variablem Schwellenwert gebildet werden.

6. Verfahren zur Herstellung einer logischen Schaltung mit Josephson-Übergang, welche wenigstens ein logisches Glied mit Josephson-Übergang, das einen supraleitenden Kreis (1) und zwei Josephson-Übergange ($J_{14}$, $J_{24}$) umfaßt, die in ihm gebildet sind und im wesentlichen gleiche kritische Ströme haben, zwei strom-Injektions-Signaleingangsleitungen ($I_{50}$, $I_{50}'$), die mit entgegengesetzten Enden einer Induktanz ($L_{15}$, $L_{16}$) in dem supraleitenden Induk- tanzkreis verbunden sind, einen Mittelabgriff (18) in der Mitte der Induktanzen ($L_{15}$, $L_{16}$) und zwei magnetisch gekoppelte Eingangssignalleitungen (16, 17) zur Injektion von Signalen in den supraleitenden Induktanzkreis hat, welches Verfahren umfaßt die Zuführung von Signalströmen ($C_1$, $C_2$) zu den magnetisch gekoppelten Eingangssignalleitungen (16, 17) und eines Vorspannungsstroms zu dem Mittelabgriff (18), um zu bewirken, daß das logische Glied mit Josephson-Übergang als ein logisches ODER-Glied wirkt, oder die Zuführung eines Versetzungsstroms zu einer der beiden magnetisch gekoppelten Eingangsleitungen (16, 17), um zu bewirken, daß das logische Glied mit Josephson-Übergang als ein logisches UND-Glied wirkt.

## Revendications

1. Circuit logique à junction de Josephson comprenant: une porte logique à junction de Josephson incluant une boucle à inductance supraconductrice (1), deux jonctions de Josephson ($J_{14}$, $J_{24}$) ayant des courants critiques essentiellement égaux ($I_0$) dans la boucle à inductance (1), deux lignes d'entrée de signaux à injection de courant ($I_{50}$, $I_{50}'$) connectées aux extrémités opposées d'un bobinage ($L_{15}$, $L_{16}$) contenu dans la boucle à inductance supraconductrice (1) et agencées pour recevoir des courants de signaux d'entrée respectifs ($I_A$, $I_B$) et une prise centrale (18) au milieu du bobinage ($L_{15}$, $L_{16}$), caractérisé en ce que deux lignes de signaux d'entrée ($C_1$, $C_2$) sont couplées magnétiquement à la boucle supraconductrice (1), la porte logique à jonction de Josephson comprenant une porte logique OU quand les courants de signaux ($I_{C1}$, $I_{C2}$) sont appliqués aux deux lignes de signaux d'entrée couplées magnétiquement ($C_1$, $C_2$) et qu' un courant de polarisation ($I_D$) est appliqué à la prise centrale (18), et la porte logique à jonction de Josephson comprenant une porte logique ET quand une des deux lignes de signaux d'entrée couplées magnétiquement ($C_1$, $C_2$) reçoit un courant de décalage.

2. Circuit logique à jonction de Josephson selon la revendication 1, qui comprend plus d'une partie logique à jonction de Josephson ($G_1$—$G_4$) (Figure 6 ou Figure 7) et dans lequel chaque porte logique à jonction de Josephson ($G_1$, $G_2$, $G_3$, $G_4$) comporte au moins trois bornes d'entrée et au moins une borne de sortie, une combinaison d'au moins deux des trois bornes d'entrée étant sélectionnée pour produire une fonction logique voulue, et un câblage étant prévu entre les bornes d'entrée sélectionnées et les bornes de sortie des portes logiques à jonction de Josephson ($G_1$, $G_2$, $G_3$, $G_4$) pour les interconnecter afin d'obtenir la fonction logique voulue.

3. Circuit logique à injection de Josephson selon la revendication 2, dans lequel les sorties de deux portes logiques OU sont connectées à l'entrée d'une porte logique ET.

4. Circuit logique à jonction de Josephson selon l'une quelconque des revendications 1 à 3, dans lequel la boucle à inductance supraconductrice (1) comporte un point mis à la masse (g).

5. Circuit logique à jonction de Josephson selon l'une quelconque des revendications 1 à 4, dans lequel les portes logiques à jonction de Josephson sont constituées par des éléments d'interférence quantique à seuil variable.

6. Procédé de fonctionnement d'un circuit logique à jonction de Josephson comportant au moins une porte logique à jonction de Josephson incluant une boucle supraconductrice (1) et deux jonctions de Josephson ($J_{14}$, $J_{24}$) formées dans celle-ci ayant des courants critiques essentiellement égaux, deux lignes d'entrée de signaux à injection de courant ($I_{50}$, $I_{50}'$) connectées aux extrémités opposées d'un bobinage ($L_{15}$, $L_{16}$) dans la boucle à inductance supraconductrice, une prise centrale (18) au milieu du bobinage ($L_{15}$, $L_{16}$), et deux lignes de signaux d'entrée couplées magnétiquement (16, 17) pour injecter des signaux dans la boucle à inductance supraconductrice (1), le procédé consistant à appliquer des courants de signaux ($C_1$, $C_2$) aux lignes de signaux d'entrée couplées magnétiquement (16, 17), et un courant de polarisation à la prise centrale (18), pour que la porte logique à jonction de Josephson fonctionne comme une porte logique OU, ou à appliquer un circuit de décalage ($C_1$, $C_2$) à une des deux lignes d'entrée couplées magnétiquement, (16, 17) pour que la porte logique à jonction de Josephson fonctionne comme une porte logique ET.

## Fig. 1A

<u>OR</u>

## Fig. 1B

# Fig. 2A
## AND

# Fig. 2B

## Fig. 3A

## Fig. 3B

## Fig. 3C

## Fig. 4A

<u>OR</u>

## Fig. 4B

## Fig. 5A

<u>AND</u>

## Fig. 5B

# *Fig.* 6

# Fig. 7

VB

$I_{of}$

$(X_1 \cdot X_2)$

$(X_1 \cdot X_2) + (X_3 \cdot X_4)$

$X_1$

$X_2$

$G_1$

$G_3$

$I_{of}$

$(X_3 \cdot X_4)$

$X_3$

$G_2$

$X_4$

$G_4$

Fig. 8 A

# Fig. 8B

$$I_G = (I_A + I_B + I_G)$$
$$I_H = (I_C + bI_A - cI_B)$$

$(a+b)L$  $(c+d)L$

$I_{01}$  $I_{02}$

# Fig. 8C

$(I_{fm}, I_0)$

$I_G$

$\Phi_0 / L$

$I_H$

$(-I_{fp}, -I_S)$

$(I_{fp}, I_S)$

$(-I_{fm}, -I_0)$

9

# Fig. 8 D